# EUROPEAN PATENT SPECIFICATION

(11) **EP 3 371 121 B1**
(45) Date of publication and mention of the grant of the patent: **09.12.2020**
(21) Application number: 16788317.2
(22) Date of filing: 12.10.2016
(51) Int. Cl.: C03C 17/245, C03C 17/34, C23C 14/58, E06B 3/66

(54) **PRODUCTION OF FLASH-TREATED INDIUM TIN OXIDE COATINGS**
HERSTELLUNGSVERFAHREN FÜR FLASH-BEHANDELTE INDIUM-ZINNOXID-BESCHICHTUNGEN
PROCÉDÉS DE PRODUCTION DES REVÊTEMENTS D'OXYDE D'ÉTAIN ET D'INDIUM À TRAITEMENT FLASH

(30) Priority: 06.11.2015 US 201514934706
(43) Date of publication of application: 12.09.2018
(73) Proprietor: Cardinal CG Company, Eden Prairie, MN 55344 (US)
(72) Inventor: BURROWS, Keith James, Mineral Point, Wisconsin 53588 (US); MYLI, Kari B., Sauk City, Wisconsin 53583 (US)
(74) Representative: Howe, Steven
(86) International application number: PCT/US2016/056523
(87) International publication number: WO 2017/078911

(56) References cited:
- WO-A1-2015/055944
- WO-A1-2015/197969
- US-A- 5 011 585
- US-A1- 2012 094 075
- US-A1- 2013 095 292

## Description

### FIELD OF THE INVENTION

The present invention relates generally to thin film coatings for glass and other substrates. More particularly, this invention relates to flash-treated transparent electrically conductive coatings based on indium tin oxide.

### BACKGROUND OF THE INVENTION

A variety of transparent electrically conductive oxide ("TCO") coatings are known in the art, for example from WO 2015/055944, US 2012/0094075 or US 5,011,585. In some cases, these coatings include an indium tin oxide ("ITO") film. To obtain a desired balance of electrical conductivity and visible transmission, ITO-based coatings are often heat treated. Known heat treatments include furnace heating, laser irradiation, flame treatment, and flash lamp treatment. Flash lamp treatment is beneficial in that it heat treats a large area of the coating with a single flash while the underlying substrate remains relatively cool.

It would be desirable to provide transparent electrically conductive coatings based on ITO that facilitate improved properties upon flash treatment. It would be particularly desirable to provide flash-treated transparent electrically conductive coatings based on ITO that provide combinations of properties improved for use on one or two exterior surfaces of a multiple-pane insulating glazing unit. It would also be desirable to provide transparent electrically conductive coatings designed for ultra-high-power flash treatment that produces flash-treated ITO-based coatings having an improved combination of properties.

It would be desirable, for example, to provide a flash-treated ITO film that has specific combinations of thickness, optical properties, and high electrical conductivity. It would also be desirable to provide a flash-treated ITO film that has pre and post flash optical bandgaps enabling good absorption, during the flash, of radiation in the range of 370-400 nm. In addition, it would be desirable to provide a flash-treated ITO film having a particular morphology that results from ultra-high-power flash treatment. The resulting film preferably would have surface roughness, carrier concentration, and absorption properties that are particularly advantageous for use on one or both exterior surfaces of a multiple-pane insulating glazing unit.

### Brief Description of the Drawings

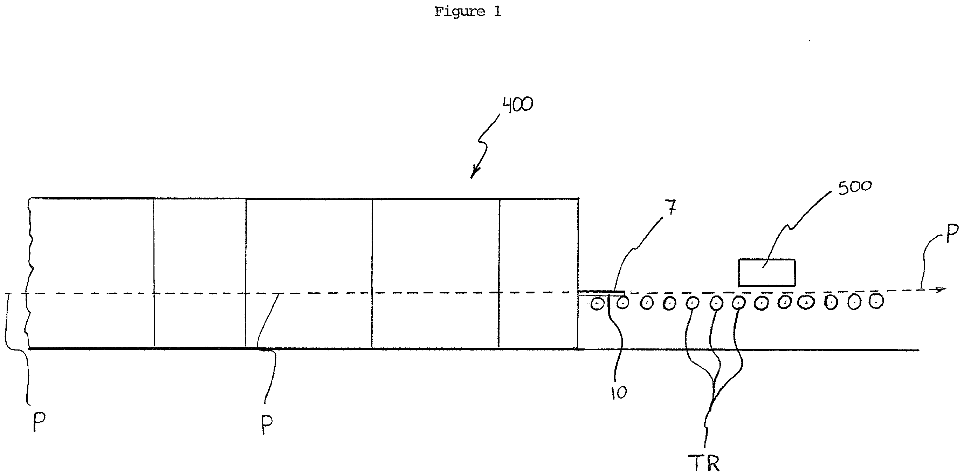

Figure 1 is a broken-away schematic side view of a production line in accordance with certain embodiments of the present invention;

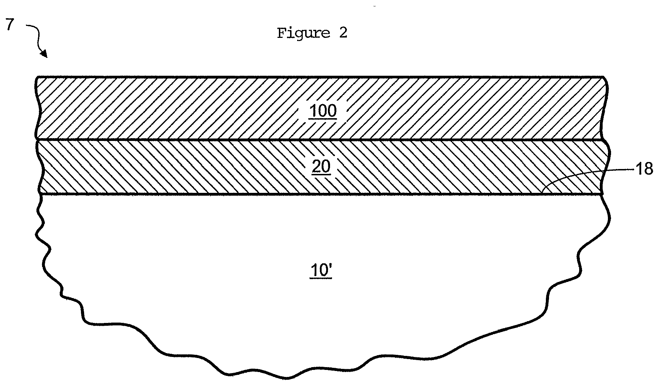

Figure 2 is a broken-away schematic cross-sectional view of a substrate bearing a transparent electrically conductive coating in accordance with certain embodiments of the invention;

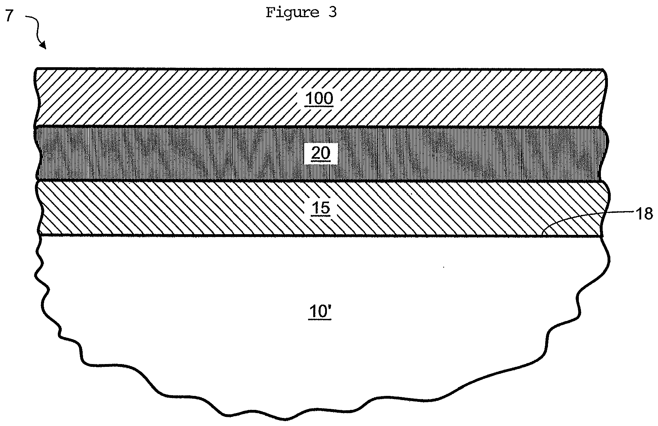

Figure 3 is a broken-away schematic cross-sectional view of a substrate bearing a transparent electrically conductive coating in accordance with other embodiments of the invention;

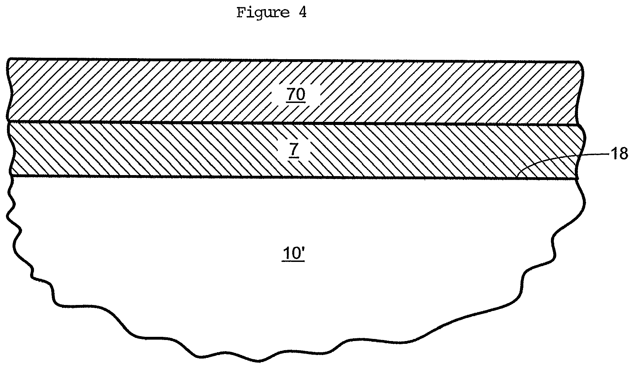

Figure 4 is a broken-away schematic cross-sectional view of a substrate bearing a transparent electrically conductive coating and a titanium-oxide containing film in accordance with still other embodiments of the invention;

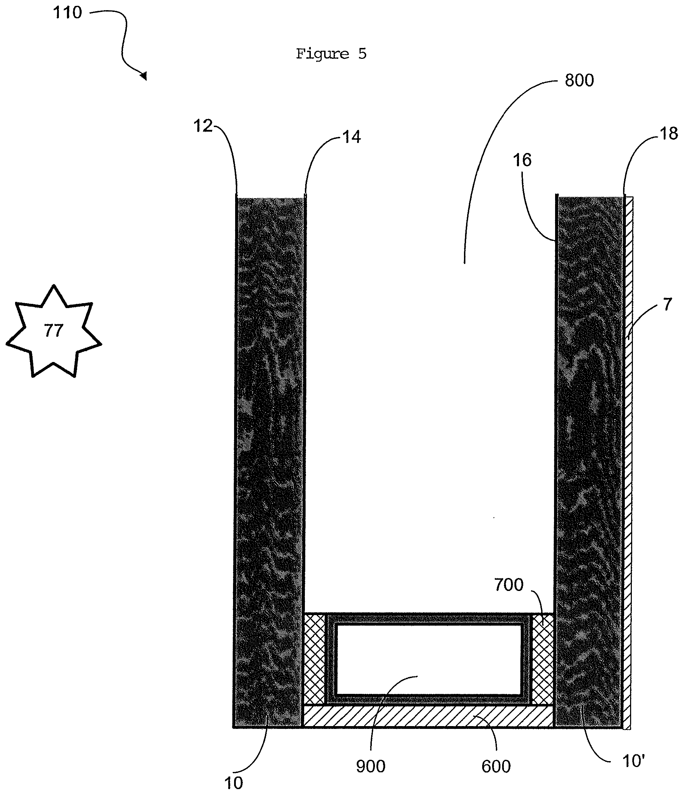

Figure 5 is a partially broken-away schematic cross-sectional side view of a multiple-pane insulating glazing unit that includes an exterior pane and an interior pane, the interior pane having a fourth surface carrying a flash-treated transparent electrically conductive coating in accordance with certain embodiments of the invention;

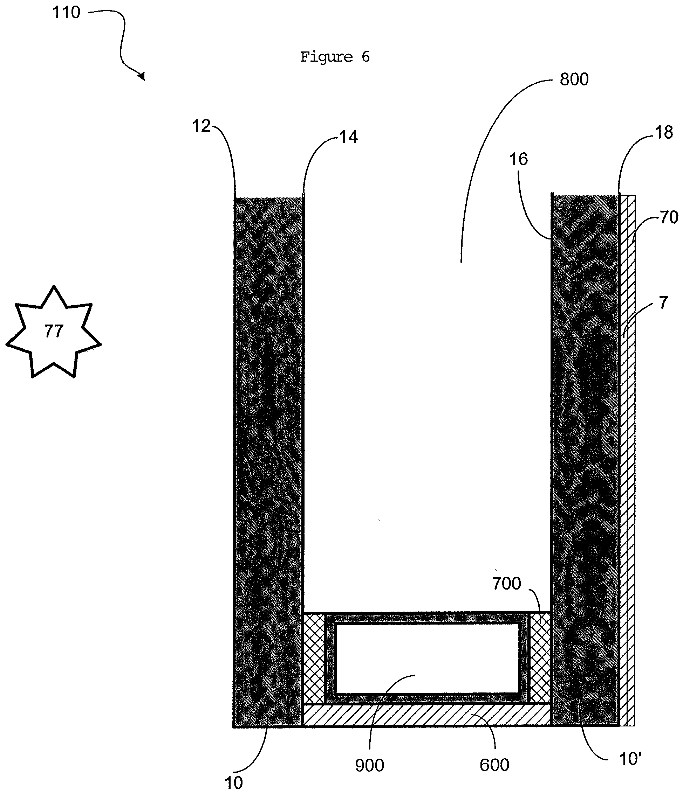

Figure 6 is a partially broken-away schematic cross-sectional side view of a multiple-pane insulating glazing unit that includes an exterior pane and an interior pane, the interior pane having a fourth surface carrying a flash-treated transparent electrically conductive coating and a hydrophilic and/or photocatalytic film in accordance with other embodiments of the invention;

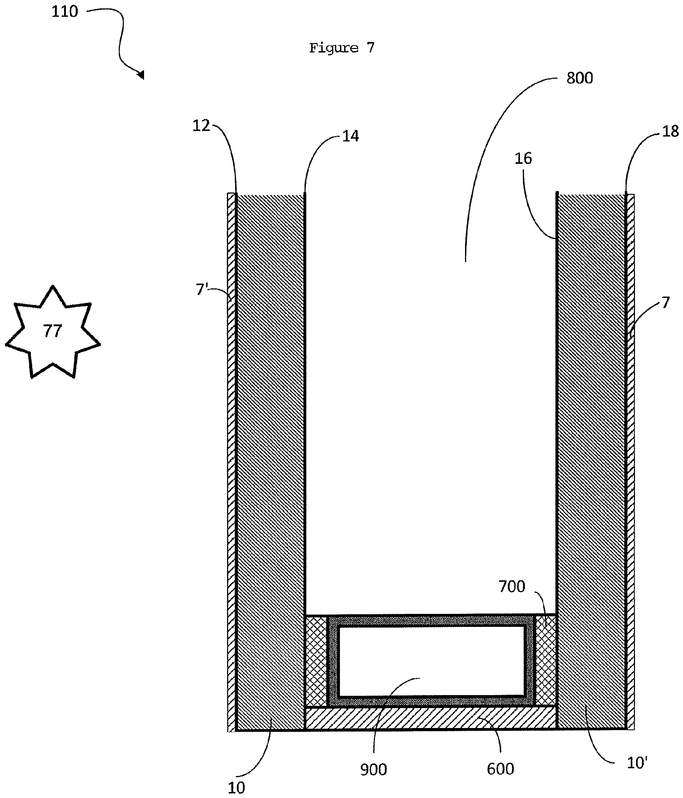

Figure 7 is a partially broken-away schematic cross-sectional side view of a multiple-pane insulating glazing unit that includes an exterior pane and an interior pane, the exterior pane having a first surface carrying a flash-treated transparent electrically conductive coating, and the interior pane having a fourth surface carrying another flash-treated transparent electrically conductive coating, in accordance with still other embodiments of the invention;

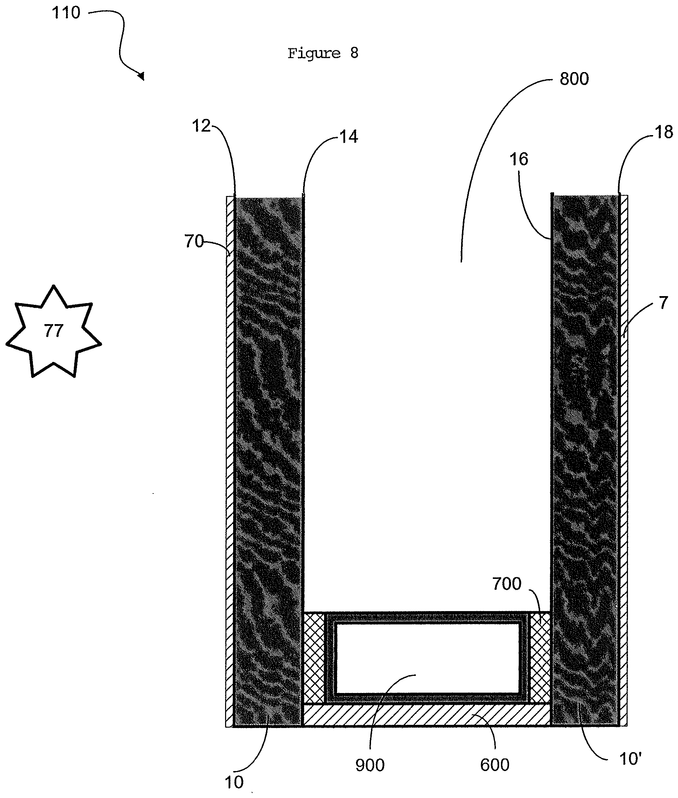

Figure 8 is a partially broken-away schematic cross-sectional side view of a multiple-pane insulating glazing unit that includes an exterior pane and an interior pane, the exterior pane having a first surface carrying a hydrophilic and/or photocatalytic film, and the interior pane having a fourth surface carrying a transparent electrically conductive coating, in accordance with yet other embodiments of the invention;

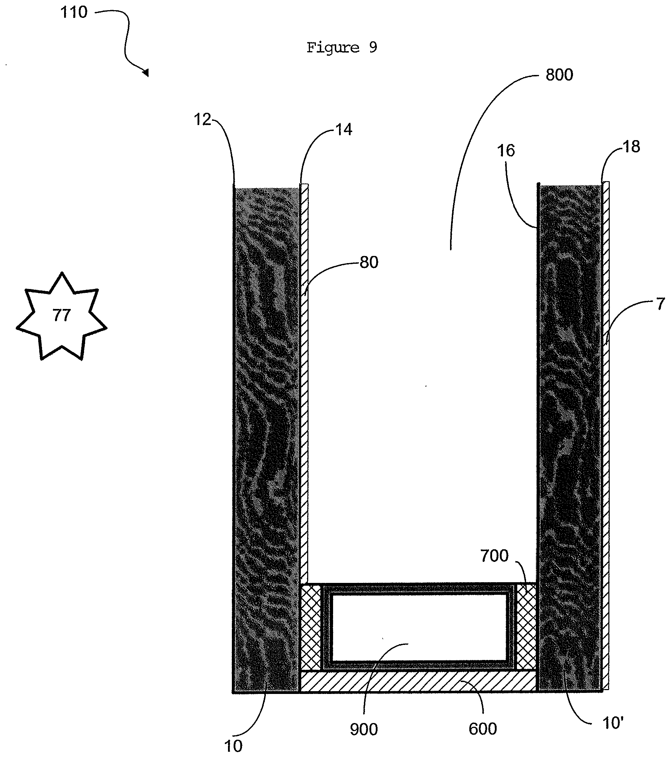

Figure 9 is a partially broken-away schematic cross-sectional side view of a multiple-pane insulating glazing unit that includes an exterior pane and an interior pane, the exterior pane having a second surface carrying a low-emissivity coating, and the interior pane having a fourth surface carrying a flash-treated transparent electrically conductive coating, in accordance with further embodiments of the invention; and

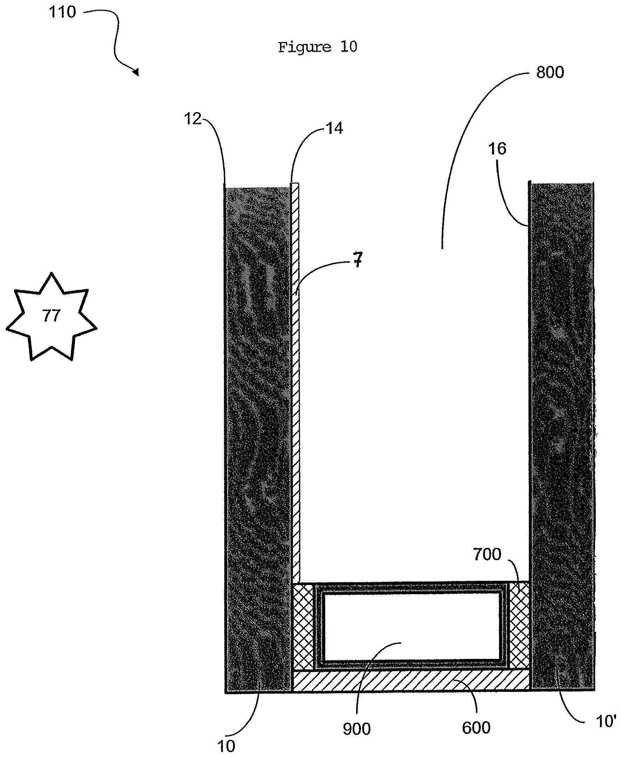

Figure 10 is a partially broken-away schematic cross-sectional side view of a multiple-pane insulating glazing unit that includes an exterior pane and an interior pane, the exterior pane having a second surface carrying a flash-treated transparent electrically conductive coating, in accordance with still other embodiments of the invention.

### Summary of the Invention

The invention provides a method of producing coated glass according to claim 1.

### DETAILED DESCRIPTION OF PREFERRED EMBODIMENTS

The following detailed description is to be read with reference to the drawings, in which like elements in different drawings have like reference numerals. The drawings, which are not necessarily to scale, depict selected embodiments and are not intended to limit the scope of the invention. Skilled artisans will recognize that the examples provided herein have many useful alternatives that fall within the scope of the invention.

The invention provides methods for producing a coated substrate. The methods involve depositing a transparent conductive coating onto a substrate and flash treating the coated substrate. Preferably, the coating is deposited by sputter deposition. In other cases, the coating is deposited by chemical vapor deposition, spray pyrolysis, sol-gel deposition, atomic layer deposition (ALD), or pulsed laser deposition. Once the coating has been deposited, it is flash treated. The present method preferably uses an ultra-high-power flash treatment system. The terms "ultra-high-power flash treatment" and "UHP flash treatment" are defined for purposes of the present disclosure to mean flash treatment at a peak pulse power of 15 kW/cm² or greater. It will be appreciated that this is higher than the peak pulse powers commonly reported for conventional flash lamp treatment.

Thus, a substrate having a surface is provided. If desired, this surface can be prepared by suitable washing or chemical preparation. A variety of substrate types are suitable for use in the invention. In some cases, the substrate is a sheet-like substrate having opposed first and second surfaces, which can optionally be rectangular. The substrate can be a sheet of transparent material (i.e., a transparent sheet). The substrate, however, is not required to be transparent.

For many applications, the substrate will comprise a transparent (or at least translucent) material, such as glass or clear plastic. For example, the substrate is a glass sheet (e.g., a window pane) in certain embodiments. A variety of known glass types can be used, such as soda-lime glass. In some cases, it may be desirable to use "white glass," a low iron glass, etc. In certain embodiments, the substrate is part of a window, door, skylight, or other glazing. Depending on the level of solar control desired, the present coating may be applied to tinted glass. Thus, the coating of any embodiment disclosed herein can optionally be provided on a sheet of tinted glass. This may provide particularly good selectivity.

Substrates of various sizes can be used in the present invention. Commonly, large-area substrates are used. Certain embodiments involve a substrate having a major dimension (e.g., a length or width) of at least about 0.5 meter, preferably at least about 1 meter, perhaps more preferably at least about 1.5 meters (e.g., between about 2 meters and about 4 meters), and in some cases at least about 3 meters. In some embodiments, the substrate is a jumbo glass sheet having a length and/or width that is between about 3 meters and about 10 meters, e.g., a glass sheet having a width of about 3.5 meters and a length of about 6.5 meters. Substrates having a length and/or width of greater than about 10 meters are also anticipated. In some embodiments, the substrate is a continuous ribbon, such as a float glass ribbon emanating from a float glass production line or a ribbon on a roll-to-roll system.

Substrates of various thicknesses can be used in the present invention. In some embodiments, the substrate (which can optionally be a glass sheet) has a thickness of 1-14 mm, such as 2-14 mm. Certain embodiments involve a substrate with a thickness of between about 2.3 mm and about 4.8 mm, and perhaps more preferably between about 2.5 mm and about 4.8 mm. In one particular embodiment, a sheet of soda-lime glass with a thickness of about 3 mm is used.

The substrate (10 or 10') has opposed surfaces (12 and 14, or 16 and 18), which preferably are major surfaces (as opposed to edge surfaces). In some cases, surface 16 is destined to be an internal surface exposed to a between-pane space of an insulating glazing unit, while surface 18 is destined to be an external surface exposed to an interior of a building. This, however, need not be the case in all embodiments.

The coating 7 is deposited onto a surface (12, 14, 16, or 18) of a substrate (10 or 10'), e.g., as one or more discrete layers, as one or more thicknesses of graded film, or as a combination including at least one discrete layer and at least one thickness of graded film. Preferably, the present method involves sputtering, e.g., DC magnetron sputtering, which is a well-known deposition technique. Reference is made to Chapin's U.S. Patent 4,166,018, the teachings of which are incorporated herein by reference. In some cases, the coating 7 is deposited by AC or pulsed DC sputtering from a pair of cathodes. HiPIMS and other modern sputtering methods can be used as well.

Briefly, magnetron sputtering involves transporting a substrate (10 or 10') through one or more low pressure zones (or "chambers" or "bays") in which the one or more film regions that make up the coating 7 are sequentially applied. To deposit oxide film, the target(s) may be formed of an oxide itself, and the sputtering may proceed in an inert or oxidizing atmosphere. To deposit indium tin oxide, for example, a ceramic indium tin oxide target can be sputtered in an inert or oxidizing atmosphere. Alternatively, oxide film can be deposited by sputtering one or more metallic targets (e.g., of metallic indium tin material) in a reactive atmosphere. Tin oxide can be deposited by sputtering one or more tin targets in a reactive atmosphere containing oxygen gas. Silicon nitride can be deposited by sputtering one or more silicon targets (which may be doped with aluminum or the like to improve conductivity) in a reactive atmosphere containing nitrogen gas. Silicon oxynitride can be deposited by sputtering one or more silicon targets (which may likewise be doped with aluminum or the like) in a reactive atmosphere containing both oxygen and nitrogen gas. Silicon dioxide can be deposited by sputtering one or more silicon targets (which may likewise be doped with aluminum or the like) in a reactive atmosphere containing oxygen gas. Titanium dioxide can be deposited by sputtering one or more titanium targets (which may be doped with tungsten or the like) in a reactive atmosphere containing oxygen gas, or by sputtering titanium sub-oxide targets in an inert gas, a reactive gas, or a mixture of both. The thickness of the deposited film(s) can be controlled by varying the speed of the substrate, by varying the power on the targets, and/or by varying the ratio of power to partial pressure of the reactive gas.

In one example, a pair of rotatable ceramic indium tin oxide targets is sputtered while an uncoated glass substrate is conveyed past the activated targets at a rate of about 36 inches per minute. The relative weight amount of the two metals is: indium 90%, tin 10%. A power of 16 kW is used, and the sputtering atmosphere is 5 mTorr with a gas flow of 900 sccm argon and 10 sccm oxygen. The resulting substoichiometric indium tin oxide film has a thickness of about 1,100 Å. Directly over this film, a silicon nitride overcoat film is applied. The silicon nitride is applied at a thickness of about 560 Å by conveying the glass sheet at about 36 inches per minute past a pair of rotary silicon aluminum targets (83% Si, 17% Al, by weight) sputtered at a power of 31.2 kW in a 5 mTorr atmosphere with a gas flow 920 sccm nitrogen. For the as-deposited film, the visible absorption is about 8.5%, the optical bandgap is about 430 nm, the carrier concentration is about 1.5 x 10²⁰/cm³, and the surface roughness is about 2.7 nm.

In another example, a pair of rotatable metallic indium tin targets is sputtered while an uncoated glass substrate is conveyed past the activated targets at a rate of about 60 inches per minute. The relative weight amount of the two metals is: indium 90%, tin 10%. A power of 16 kW is used for the pair of rotary targets. The sputtering atmosphere is 5 mTorr with a gas flow of 601 sccm argon and 100 sccm oxygen. The resulting substoichiometric indium tin oxide film has a thickness of about 1,240 Å. Directly over this ITO film, a silicon nitride overcoat film is applied. The silicon nitride is applied at a thickness of about 600 Å by conveying the glass sheet at about 60 inches per minute sequentially past a pair of rotary silicon aluminum targets (83% Si, 17% Al, by weight) sputtered at 38.6 kW in a 5 mTorr atmosphere with a gas flow 450 sccm argon and 451 sccm nitrogen. For the as-deposited film, the visible absorption is about 10.5%, the optical bandgap is about 420 nm, the carrier concentration is about 2.5 x 10²⁰/cm³, and the surface roughness is about 2.9 nm.

The foregoing examples are by no means required. Many other sputter deposition processes can be used to deposit the coating 7 onto the substrate (10 or 10'). Moreover, chemical vapor deposition, spray pyrolysis, sol-gel deposition, atomic layer deposition (ALD), or pulsed laser deposition can alternatively be used.

Figure 1 schematically depicts a production line having both a sputter coater 400 and a flash treatment device 500. Here, the flash treatment device 500 is located on the production line downstream of the coater 400. The flash treatment device can alternatively be located within the coater. Another possibility is to provide the flash treatment device 500 on a processing line separate from the sputter coater 400. The flash treatment device 500, for example, may be in a facility different from the coating facility. Either way, the sputtering line 400 will typically include a series of connected sputter deposition chambers through which a path of substrate travel P extends. The path of substrate travel P can be defined, for example, by a series of spaced-apart transport rollers TR.

The flash treatment device 500 preferably has a single row of flash lamps, although this is not strictly required. The flash lamps can be, for example, xenon flash lamps each having a diameter larger than 15 mm. The flash lamps can be spaced apart by, for example, about three inches on center across the width of the system, with the axis of the lamp aligned in the direction of travel of the substrate. As one non-limiting example, for a 96 inch width of treated glass area, 32 lamps may be used. The lamps preferably each have a length of six inches, although other lengths (e.g., longer lengths) can alternatively be used. A concentrating reflector is mounted behind each lamp, e.g., such that the lamp uniformly illuminates a 3 inch x 6 inch area (or, in the case of longer lamp lengths, larger areas can be uniformly illuminated).

As another possibility, the flash treatment device 500 can include one or more lamps each having their axis cross-wise to the direction of substrate travel. Lamps of various lengths can be used in such cases, depending upon the requirements of a given system and its intended applications.

The present flash treatment involves a peak pulse power in the range of 15-45 kW/cm², or even 20 kW/cm² or greater, e.g., in the range of 20-45 kW/cm². Thus, the present flash treatment preferably is UHP flash treatment. Thus, the flash-treated indium tin oxide film may have a morphology characterized by UHP flash-treatment at 15-45 kW/cm². Due to the rapid temperature change of the film, a distinctive average stress condition may result.

When the device 500 flashes, it preferably emits a pulse packet of between 1 and 20 pulses. These pulses can be as long as 5 milliseconds, but preferred recipes involve 5-15 pulses, each being between 50 and 200 microseconds, with an off-time in the range of 50-100 microseconds between each pulse. One exemplary pulse packet is about 2 milliseconds in length (including on and off time). The pulse is powered by a charged capacitor bank. The energy contained in the pulse is affected by the length of the pulse, as well as the voltage at which the capacitors have been charged. The voltage range preferably is between 650 V and 950 V. The total energy contained in a pulse packet is up to about 30 J/cm², and preferably is in the range of from 18 J/cm² to 24 J/cm². The peak power of the pulse preferably is 15 kW/cm² or greater, e.g., in the range of 15-45 kW/cm², or even 20 kW/cm² or greater, e.g., in the range of 20-45 kW/cm².

The system is able to flash up to approximately two such pulse packets per second (limited by the capacitor recharging rate). A single pulse packet is sufficient to convert the film, but there may be some overlap of pulse packets (e.g., 10%) to ensure the film is fully treated. In certain embodiments, each pulse treats 6 inches in the direction of travel (preferably with a 10% overlap), and the line speed is as high as about 650 inches per minute (e.g., 5.4 + 5.4 = 10.8 inches per second). Equipment of this nature is commercially available from Ncc Nano LLC of Austin, Texas, U.S.A.

Thus, the invention provides a method for producing flash-treated coated glass. The method involves providing a glass substrate (10 or 10') having opposed first (12 or 18) and second (14 or 16) surfaces. An indium tin oxide film 20 is deposited onto a surface (12, 14, 16, or 18) of the glass pane (10 or 10'). The indium tin oxide film 20, as deposited, is a sub-oxide (i.e., its oxygen content is substoichiometric). The deposition technique can be, for example, in accordance with either of the two non-limiting sputter deposition examples detailed above. Other deposition methods can alternatively be used. Preferably, the method involves sputtering a metallic indium tin target in an oxidizing atmosphere. One such deposition technique is the second of the two non-limiting sputter deposition examples detailed above. The substoichiometric indium tin oxide film (i.e., the film 20 as deposited) has a thickness of less than 1,800 Å, a surface roughness of less than 3 nm, an optical bandgap of 400 nm or longer, and optionally a carrier concentration of 5 x 10²⁰/cm³ or less.

Thus, the thickness of the substoichiometric indium tin oxide film (i.e., the film 20 as deposited) is less than 1,800 Å, such as between 100 Å and 1,800 Å. In some cases, the thickness is less than 1,600 Å, such as between 100 Å and 1,600 Å, or even less than 1,500 Å, such as greater than 100 Å but less than 1,500 Å. In preferred embodiments, the thickness is between 1,050 Å and 1,450 Å. Any embodiment disclosed herein can provide the thickness of film 20 in this range. The thicknesses recited herein are physical thicknesses unless otherwise specified to be optical thicknesses. Thus, in some embodiments, the substoichiometric indium tin oxide film (i.e., the film 20 as deposited) has a thickness of less than 1,500 Å, a surface roughness of less than 3 nm, an optical bandgap of 400 nm or longer, and optionally a carrier concentration of 5 x 10²⁰/cm³ or less.

As noted above, the substoichiometric indium tin oxide film (and the coating 7) has a surface roughness Rₐ of less than 3 nm. In preferred embodiments, the surface roughness Rₐ is between 1.5 nm and 3 nm, such as between 2.0 nm and 3.0 nm. Surface roughness is defined in terms deviations from the mean surface level. The surface roughness Rₐ is the arithmetical mean surface roughness. This is the arithmetic average of the absolute deviations from the mean surface level. The arithmetical mean surface roughness of a coating is commonly represented by the equation: Rₐ= 1/L ∫₀^{L} | *f*(x) | dx. The surface roughness Rₐ can be measured in conventional fashion, e.g., using an Atomic Force Microscope (AFM) equipped with conventional software that gives Rₐ. Thus, in some embodiments, the substoichiometric indium tin oxide film (i.e., the film 20 as deposited) has a thickness of greater than 100 Å but less than 1,500 Å, a surface roughness of between 1.5 nm and 3 nm, an optical bandgap of 400 nm or longer, and optionally a carrier concentration of 5 x 10²⁰/cm³ or less.

In connection with the optical bandgap of the substoichiometric indium tin oxide film, because it is 400 nm or longer (and hence in the visible region), the film 20 as deposited has lower transmission in the visible range. The optical bandgap determines the portion of the solar spectrum that the indium tin oxide film 20 will absorb; photons with an energy level less than that of the bandgap are not absorbed. The optical bandgap can be determined from the optical absorption spectrum of the material using a Tauc Plot. This method is well known to skilled artisans. In any embodiment of the present disclosure, the optical bandgap of the substoichiometric indium tin oxide film can optionally be 410 nm or longer, or even 420 nm or longer.

The carrier concentration of the indium tin oxide film 20 is relatively low as deposited. Thus, the as-deposited film is not very conductive. In certain preferred embodiments, the film 20 is deposited so its carrier concentration is 5 x 10²⁰/cm³ or less, such as in the range of about 1-2.5 x 10²⁰/cm³. The carrier concentration can be determined using the van der Pauw Method, which is well known to skilled artisans.

In addition, the substoichiometric indium tin oxide film preferably is non-porous, or at least substantially non-porous. Porosity is a measure of the volume fraction of voids (empty space or a gas or liquid phase separate from the film material) in a film, also called the void fraction.

It is to be appreciated, however, that it is merely optional to provide the film 20 in non-porous or substantially non-porous form. Another option is to have higher amounts of porosity. While this may decrease the electrical conductivity of the film 20, it may also reduce its index of refraction, which may be advantageous for certain applications. Porosity can be provided using methods well known to skilled artisans, such as increasing the pressure during sputtering.

The method further includes flash treating the substoichiometric indium tin oxide film so as to produce a flash-treated indium tin oxide film. The flash treatment equipment and process parameters described above can optionally be used. While an UHP technique is preferred, it is not required. Similarly, the equipment arrangement details discussed above are optional. Skilled artisans will be able to readily design and use many other flash treatment equipment arrangements and process parameters given the present teaching as a guide.

The flash-treated indium tin oxide film has a thickness of less than 1,800 Å, a surface roughness of less than 3 nm, an optical bandgap of 370 nm or shorter, optionally a carrier concentration of 9 x 10²⁰/cm³ or more, and a sheet resistance of less than 30 Ω/square (in some cases, less than 15 Ω/square) in combination with providing the coated glass substrate with a monolithic visible transmittance of greater than 0.82, or even greater than 0.85.

The flash treatment advantageously crystallizes the indium tin oxide film 20, improves grain size, heals intra-grain defects, oxidizes the film (and decreases visible absorption), optionally together with activating dopant(s) in the film. As noted above, the carrier concentration of the as-deposited indium tin oxide film is relatively low. It is therefore not very conductive. And because its optical bandgap is in the visible region, the film 20 as deposited has lower transmission in the visible range. As a result of the flash treatment, the optical bandgap of the film 20 shifts to a higher energy/shorter wavelength. By shifting the bandgap from 400 nm or longer (pre-flash) to 370 nm or shorter (post-flash), the indium tin oxide film 20 is capable of absorbing energy emitted by the flash in the 370 to 400 nm range. The mechanism that causes the bandgap to shift when the carrier concentration increases is the Burstein Moss Effect.

The flash treatment preferably produces a carrier concentration factor of at least 5. That is, the carrier concentration of the flash-treated indium tin oxide film preferably is at least 5 times greater than the carrier concentration of the substoichiometric indium tin oxide film (i.e., the film 20 as deposited). In some embodiments, the carrier concentration factor is at least 7.5.

The carrier concentration of the as-deposited film can optionally be in the range of 1-2.5 x 10²⁰/cm³. The flash treatment provides a great carrier concentration increase. In certain preferred embodiments, the carrier concentration of the flash-treated indium tin oxide film is 9 x 10²⁰/cm³ or more, such as in the range of 9-13 x10²⁰/cm³. It is to be appreciated, however, that the preferred carrier concentrations and carrier concentration factors noted in this paragraph and the preceding paragraph are optional.

The flash treatment lowers the sheet resistance of the indium tin oxide film 20. The post-flash sheet resistance is less than 30 Ω/square, such as 5-28Q/square. In certain preferred embodiments, it is less than 15 Ω/square, less than 14 Ω/square, or even less than 13 Ω/square, such as 10-13Ω/square. Sheet resistance can be measured in standard fashion using a non-contact sheet resistance meter.

The flash treatment preferably produces a controlled Δ*A* for the indium tin oxide film 20. The term Δ*A* is defined, for purposes of the present disclosure, as being the magnitude of the reduction of the visible absorption of the indium tin oxide film 20 caused by the flash treatment. As is well-known to skilled artisans, visible absorption (expressed as a percentage) equals 100 minus Tᵥᵢₛ minus Rᵥᵢₛ, Preferably, the Δ*A* is five percent or more, seven percent or more, or even nine percent or more. In certain preferred embodiments, the visible absorption of the substoichiometric indium tin oxide film (i.e., the film 20 as deposited) is greater than 7%, e.g., in the range of 7.5-12%. After flash treatment, the visible absorption preferably is less than 5%, such as 0.5-4.5%, perhaps optimally 1-4%.

The flash treatment can optionally be preceded by a step of pre-heating the coated glass. In some embodiments, prior to flash treating the coated substrate, it is heated to a temperature of greater than 50 degrees C, or even greater than 75 degrees C, such as about 100-125 degrees C. The optional preheating can be conducted using an electric furnace, a natural gas furnace, or infrared lamps. As just one example, a pre-heating system can optionally be positioned between the coater 400 and the flash-treatment device 500 in the embodiment of Figure 1.

The flash treatment is advantageous in that it, while it heats the coating 7 to an extremely high temperature, the heating period is incredibly short, so the glass substrate (10 or 10') experiences relatively little heat gain. For example, the opposite surface of the glass pane is maintained at a temperature of 150 degrees C or lower (preferably lower than 125 degrees C) during the flash treatment. This is desirable for several reasons. First, the annealed state of a coated glass substrate can be maintained even after flash treatment; the glass can thus remain cut-able. Second, the glass is not subjected to the types of deformations (e.g., roller wave distortion) that can occur in conventional furnace tempering. Third, the time, energy, and cost savings are considerable.

The flash-treated indium tin oxide film has a low sodium concentration. Preferably, the sodium concentration is less than 100 ppm, less than 10 ppm, or even less than 1 ppm. During heat treatment, sodium can migrate from substrate materials like soda-lime glass into an overlying coating. (In preferred embodiments, the or each glass substrate is soda-lime glass.) It is desirable to keep the ITO film 20 as sodium-free as possible. When a significant amount of sodium is present in an ITO film, its long term stability and performance may be negatively impacted. Since flash treatment subjects the glass substrate to far less heat than furnace tempering and other conventional heat treatments, the present flash method is beneficial in terms of avoiding sodium poisoning. The sodium concentration can be measured using secondary ion mass spectroscopy, which is a technique well known in the present field.

The thickness of the indium tin oxide film 20 after flash treatment is less than 1,800 Ǻ, such as between 100 Å and 1,800 Å. In certain preferred embodiments, the thickness of the flash-treated indium tin oxide film is less than 1,600 Å (but greater than 100 Å), or even less than 1,500 Å (but greater than 100 Å), and yet its sheet resistance is less than 15 Q/square, or even less than 13 Q/square. The thickness can be, for example, between 1,050 Å and 1,800 Å, such as between 1,050 Å and 1,450 Å. In certain preferred embodiments, the thickness is in this range and the monolithic visible transmittance of the coated glass substrate (10 or 10') is greater than 0.86 but less than 0.92 while the sheet resistance of the flash-treated ITO film is greater than 10 Q/square but less than 15 Q/square (or less than 13 Q/square).

In some embodiments, the flash-treated indium tin oxide film has a thickness of greater than 100 Ǻ but less than 1,500 Å, a surface roughness of greater than 1.5 nm but less than 3 nm, an optical bandgap of 370 nm or shorter, optionally a carrier concentration of 9 x 10²⁰/cm³ or more, and a sheet resistance of less than 30Q/square in combination with providing the coated glass pane with a monolithic visible transmittance of greater than 0.85.

In preferred embodiments, the present method further includes depositing an overcoat film onto the substoichiometric indium tin oxide film. When provided, the overcoat film preferably is sputter deposited to a thickness of between 100 Å and 1,300 Å. The overcoat film can be formed of various materials. For example, it can be formed of silicon nitride, silicon oxynitride, silicon dioxide, tin oxide, titanium oxide, or titanium oxynitride.

In certain embodiments, the overcoat film 100 is formed of an oxide material deposited directly onto the indium tin oxide film 20, and the indium tin oxide film is deposited directly onto a surface (12, 14, 16, or 18) of the glass substrate (10 or 10'). As noted above, the glass substrate preferably is soda-lime glass. In the present embodiments, even though the coating 7 does not have a sodium ion diffusion barrier layer, the flash-treated indium tin oxide film has a sodium concentration of less than 100 ppm, less than 10 ppm, or even less than 1 ppm.

Thus, the present invention provides a coated glass substrate having a flash-treated transparent electrically conductive coating. In Figures 2 and 3, substrate 10' bears a transparent electrically conductive coating 7. In these figures, the coating 7 includes a flash-treated indium tin oxide film 20 and an overcoat film 100. In the embodiment of Figure 3, the coating 7 includes, from surface 18 outwardly, an optional base film 15, the flash-treated indium tin oxide film 20, and the overcoat film 100. Films 15, 20, and 100 can be provided in the form of discrete layers, thicknesses of graded film, or a combination of both including at least one discrete layer and at least one thickness of graded film. While the base film 15 is shown as a single layer, it can alternatively be a plurality of layers. Preferably, all the films in the coating 7 are oxide, nitride, or oxynitride films. Certain embodiments provide the coating 7 in the form of multiple layers of different oxide materials (e.g., such that that the coating 7 consists of a plurality of different oxide films). Preferably, all the films in the coating 7 are sputtered films.

While Figures 2-4 show the coating 7 on surface 18 of substrate 10', this coating can alternatively be provided on surface 16 of substrate 10', on surface 12 of substrate 10, or on surface 14 of substrate 10. More generally, the present disclosure contemplates the flash-treated coating 7 being provided on any surface of a glass substrate, whether or not it is part of a multi-pane insulating glass unit. In embodiments where the coating 7 is on a pane that is part of an IG unit, this coating can either be on an external surface (such as a #1 surface or a #4 surface) of the IG unit or on an internal surface (such as a #2 surface or a #3 surface) of the IG unit.

The coating 7 preferably is formed of materials, and made by a process (such as one of those described above), that allow the coated substrate to have a haze level of less than 0.5 or less than 0.3 (e.g., less than 0.2, less than 0.1, or even less than 0.09), a roughness Rₐ of less than 3 nm, and a monolithic visible transmittance of greater than 0.82 (preferably greater than 0.85, or even greater than 0.86). It is to be appreciated, however, that these properties are optional. For example, higher haze levels may be provided in certain embodiments.

Haze can be measured in well-known fashion, e.g., using a BYK Haze-Gard plus instrument. Reference is made to ASTM D 1003-00: Standard Test method for Haze and Luminous Transmittance of Transparent Plastics, the contents of which are incorporated herein by reference.

In certain preferred embodiments, the coated substrate has a haze of less than 0.3 and a surface roughness of less than 3 nm, together with a monolithic visible transmittance (after flash treatment) of greater than 0.82, or even greater than 0.85, in combination with the flash-treated ITO film having a Rₛₕₑₑₜ of less than 15 ohms/square, or even less than 13 ohms/square, such as about 11.5 to 12.5 ohms/square.

As noted above, the coating 7 has low surface roughness. Preferably, the flash-treated coating has a surface roughness Rₐ of less than 3 nm, such as from 1.5 nm to 3.0 nm. The deposition method parameters preferably are chosen to provide the coating with such a roughness. Alternatively, the coating could be polished or roughened after deposition to provide the desired surface roughness. While the flash treatment may increase the surface roughness by a certain amount (e.g., 0-10%), the final surface roughness preferably is in the ranges noted above.

The flash treated coated substrate can have particularly good flatness. For example, the coated glass substrate of any embodiment of this invention can, even after flash treatment, meet the specifications for allowable annealed glass distortion specified in ASTM 1036-11, the teachings of which are hereby incorporated herein by reference.

When provided, the optional base film 15 can comprise, consist essentially of, or consist of silica, alumina, or a mixture of both. In other embodiments, the base film 15 comprises titanium dioxide. In still other embodiments, the base film 15 comprises tin oxide (e.g., SnO₂). In such embodiments, the base film 15 may be devoid of indium. For example, a base film 15 consisting of (or at least consisting essentially of) tin oxide is provided in some cases. Compounds of two or more of silica, alumina, titanium dioxide, and tin oxide can be used. Alternatively, other dielectric films may be used. As noted above, the invention also provides embodiments wherein the base film is omitted.

The indium tin oxide film 20 comprises indium tin oxide, optionally together with one or more other materials. If desired, zinc, aluminum, antimony, fluorine, carbon nanotubes, or other components can be included in the film. Preferably, the indium tin oxide film 20 consists essentially of (e.g., contains more than 95% by weight), or consists of, indium tin oxide. The indium tin oxide film 20 can contain various relative percentages of indium and tin. On a metal-only basis, indium is the major constituent. That is, indium accounts for more than 50% of the film's total metal weight. Preferably, the composition of the film on a metal-only basis ranges from about 75% indium/25% tin to about 95% indium/5% tin, such as about 90% indium/10% tin.

In any embodiment of the present disclosure, the indium tin oxide film 20 can optionally be replaced with another type of transparent conductive oxide film. A few well-known examples include fluorinated tin oxide ("FTO"), a doped zinc oxide, such as aluminum-doped zinc oxide ("AZO"), or a doped titanium dioxide, such as niobium-doped TiO₂ ("NTO").

The overcoat film 100 is located over the indium tin oxide film 20. In some cases, the overcoat film 100 comprises tin oxide. In such cases, the tin oxide-containing overcoat film is devoid of indium oxide. In certain embodiments, the overcoat film 100 contains at least 75% tin, at least 85% tin, or at least 95% tin (on a metal-only basis), while also being devoid of indium oxide. For example, the overcoat film 100 may consist of (or at least consist essentially of) tin oxide (e.g., SnO₂). Alternatively, the overcoat film can comprise silicon nitride, silicon oxynitride, or both. Further, some embodiments provide the overcoat film 100 in the form of an oxide material, such as silicon dioxide.

The coating 7 can optionally include a nitride film between the indium tin oxide film 20 and the overcoat film 100. When provided, the nitride film may comprise one or more of silicon nitride, aluminum nitride, and titanium nitride. For example, a thin film of silicon nitride can optionally be positioned directly between (i.e., so as to contact both) the indium tin oxide film and the overcoat film. When provided, this silicon nitride film (which can optionally include a small amount of aluminum) may have a thickness of less than 250 Å, or even less than 200 Å, e.g., about 150 Å.

In other embodiments, the overcoat film 100 is in contact with the indium tin oxide film 20. Providing the overcoat film 100 directly over (i.e., so as to be in contact with) the underlying indium tin oxide film 20 can be advantageous. For example, providing fewer layers and interfaces may be desirable in connection with optical properties, stress, or both. Moreover, material, energy, and cost can be conserved by providing fewer layers. Also, when the overcoat film 100 comprises tin oxide, while it has a different composition than the indium tin oxide film 20, both contain tin oxide and may thus have particularly good adhesion to each other.

When provided, the optional base film 15 has a thickness of 50 Å or more, such as about 70-300 Å. In certain embodiments, the coating includes a base film of silica (optionally including some alumina), alumina, titanium dioxide, or tin oxide at a thickness of 75-150 Å. The invention also provides embodiments wherein the indium tin oxide film 20 is directly on (i.e., in contact with) the surface of the substrate, which may be soda-lime float glass.

The coating 7 can optionally further include an oxynitride film located on the overcoat film 100. When provided, this oxynitride film can have a thickness of between 100 Å and 1,300 Å, such as between 400 Å and 900 Å. The oxynitride film can optionally be directly over (i.e., so as to contact) the overcoat film 100. The oxynitride film may comprise aluminum, oxygen, and nitrogen. In some cases, the oxynitride film is an exposed outermost film of the coating 7.

In certain embodiments, the optional oxynitride film comprises silicon oxynitride at a thickness of between 400 Å and 900 Å. The silicon oxynitride may, for example, be sputter deposited from one or more silicon-aluminum targets, such as elemental targets comprising a sputterable material consisting of about 83% silicon and 17% aluminum.

Some embodiments of the invention provide a film comprising titanium oxide 70 over the transparent electrically conductive coating 7. Reference is made to Figure 4. When provided, the film comprising titanium oxide 70 preferably is an exposed, outermost film. Thus, when both the optional oxynitride film and the optional film comprising titanium oxide 70 are provided, the film comprising titanium oxide preferably is located over the oxynitride film. In preferred embodiments, the film comprising titanium oxide 70 has a thickness of less than 200 Å, such as from 10-75 Å, e.g., about 50 Å.

When provided, the film comprising titanium oxide 70 preferably is photocatalytic, hydrophilic, or both. Suitable films of this nature are described in U.S. Patent and Application Nos. 7,294,404 and 11/129,820 and 7,713,632 and 7,604,865 and 11/293,032 and 7,862,910 and 7,820,309 and 7,820,296.

In some embodiments, the coated substrate (10 or 10') is part of a monolithic glazing. In other embodiments, the coated substrate is part of a multi-pane insulating glazing unit ("IG unit") 110. Reference is made to Figures 5-10, which depict double-pane IG unit embodiments. It is to be appreciated that the IG unit 110 can alternatively have three or more panes.

The IG unit 110 includes two glass panes. The two panes respectively define two opposed external pane surfaces. In addition, the two panes respectively define two confronting internal pane surfaces. In the double-pane IG unit embodiments of Figures 5-10, the two panes 10, 10' respectively define two confronting internal pane surfaces 14, 16 that are both exposed to a single between-pane space 800. In triple-pane IG unit embodiments, the two panes that respectively define the two opposed external pane surfaces also respectively define two confronting internal pane surfaces, but those confronting internal pane surfaces are exposed to different between-pane spaces.

At least one external or internal pane surface of the IG unit has a flash-treated transparent conductive oxide coating, such that a desired one of the glass panes is a coated glass pane. This coated glass pane is annealed glass having a surface stress of less than 3,500 psi, preferably less than 3,000 psi, such as 2,500 psi or less. Surface stress can be determined using a grazing angle surface polarimeter as specified in ASTM C1048 and ASTM C1279, the teachings of which are incorporated herein by reference.

The IG unit 110, while shown as a double-pane unit, can alternatively be a triple-pane unit comprising three glass panes. In such cases, the middle pane can optionally be heat strengthened or tempered, while the two outer panes are annealed. Another option is for one or both of the outer panes of a triple-pane unit to be heat strengthened or tempered while the middle pane is annealed. Furthermore, in double-pane IG unit embodiments, the flash-treated coated glass pane can be annealed while the other glass pane is heat strengthened or tempered. Or, all the glass panes of any embodiment of the present disclosure can optionally be annealed.

Some embodiments provide an IG unit that includes at least one annealed glass pane and at least one tempered or heat strengthened glass pane, where the annealed glass pane has a flash-treated transparent electrically conductive coating 7 while the tempered or heat strengthened glass pane has its own transparent electrically conductive coating. In these embodiments, the two transparent electrically conductive coatings can optionally be different, e.g., they may have different layer stacks, different TCO film thicknesses, or just different TCO film morphologies or characteristics.

In one group of embodiments, the flash-treated transparent electrically conductive coating 7 is on a #4 surface, a #6 surface, or another external surface of the inboard pane of an IG unit. By providing the transparent electrically conductive coating 7 on this surface, the temperature of the indoor pane under certain conditions can be decreased. In such cases, by providing a photocatalytic and/or hydrophilic film comprising titanium oxide 70 over the transparent electrically conductive coating 7, any condensation that may occur on the room-side surface may be more readily formed into a sheet and evaporated. Reference is made to the embodiment shown in Figure 6.

The "first" (or "#1") surface is exposed to an outdoor environment. Accordingly, it is the #1 surface that radiation from the sun first strikes. The external surface of the outboard pane is the so-called first surface. Moving from the #1 surface toward the interior of the building, the next surface is the "second" (or "#2") surface. Thus, the internal surface of the outboard pane is the so-called second surface. Moving further toward the interior of the building, the next surface is the "third" (or "#3") surface, followed by the "fourth" (or "#4") surface. This convention is carried forward for IG units having more than four major pane surfaces. Thus, for a triple-pane IG unit, the #6 surface would be the external surface of the inboard pane.

One group of embodiments provides a triple glazing (e.g., an IG unit having three panes), and the flash-treated transparent electrically conductive coating is provided on the #6 surface. In embodiments of this nature, the #1 and/or #2 surfaces can optionally have other functional coatings. The #2 surface, for example, may have a silver-based low-emissivity coating, and/or the #1 surface may have another transparent electrically conductive coating, a photocatalytic coating, an antireflection coating, or a UV-blocking coating. One example is a triple-pane IG unit having the flash-treated transparent electrically conductive coating provided on the #6 surface, a triple-silver low-emissivity coating on the #2 surface, and a single-silver low-emissivity coating on the #4 surface. Another example is a triple-pane IG unit having the flash-treated transparent electrically conductive coating provided on the #6 surface, a triple-silver low-emissivity coating on the #2 surface, and another transparent electrically conductive coating on the #4 surface.

In Figures 5-10, substrate 10' is a transparent glass pane that is part of an IG unit 110. The IG unit 110 has an exterior pane 10 and an interior pane 10' separated by at least one between-pane space 800. A spacer 900 (which can optionally be part of a sash) is provided to separate the panes 10 and 10'. The spacer 900 can be secured to the internal surfaces of each pane using an adhesive or seal 700. In some cases, an end sealant 600 is also provided. In the illustrated embodiments, the exterior pane 10 has an external surface 12 (the #1 surface) and an internal surface 14 (the #2 surface). The interior pane 10' has an internal surface 16 (the #3 surface) and, in some cases (i.e., when the IG unit is a double-pane unit), an external surface 18 (the #4 surface). In other embodiments, the IG unit 110 has three panes, such that the external surface of the inboard pane is the #6 surface.

The IG unit 110 can optionally include a laminated glass panel. In such cases, the laminated glass panel may be a switchable smart panel or a conventional non-switchable laminated glass panel (i.e., laminated glass that is not switchable between different optical states).

The IG unit 110 can optionally be mounted in a frame (e.g., a window frame, which may be a sash) such that the external surface 12 of the exterior pane 10 is exposed to an outdoor environment 77 while the external surface 18 of the interior pane 10' is exposed to a room-side interior environment. Each internal surface of the IG unit 110 is exposed to a between-pane space 800 of the IG unit. When the IG unit is a triple-pane IG unit, it will have two between-pane spaces. In some cases, the IG unit 110 is a vacuum IG unit.

The IG unit 110 includes at least one flash-treated transparent electrically conductive coating of the nature described above. In the embodiment of Figure 5, for example, the external surface 18 of pane 10' has the flash-treated transparent electrically conductive coating 7. Here, the illustrated coating 7 is exposed to an environment (in some cases, a temperature-controlled living space) inside a residential building or another building.

The IG unit 110 can optionally bear one or more films comprising titanium oxide 70, such as a hydrophilic and/or photocatalytic film. In the embodiment of Figure 8, for example, a film comprising titanium oxide 70 is provided on the external surface 12 of pane 10, so as to be exposed to an outdoor environment 77 (and thus in periodic contact with rain). The film comprising titanium oxide 70 can be part of a photocatalytic and/or hydrophilic coating. If desired, the IG unit 110 can bear two films comprising titanium oxide, e.g., one such film on the external surface 12 of pane 10 and another such film over a flash-treated transparent electrically conductive coating 7 on the external surface 18 of pane 10' (or one such film on the external surface 18 of pane 10' and another such film over a flash-treated transparent electrically conductive coating on the external surface 12 of pane 10).

Thus, in some cases, there are two films comprising titanium oxide on the IG unit. When provided, these two films may be different. For example, the external surface of the outboard pane and the external surface of the inboard pane can both have photocatalytic films, but they can be different (e.g., in terms of thickness or composition). If desired, a photocatalytic film on the external surface of the inboard pane can be responsive to activation by indoor light, while a photocatalytic film on the external surface of the outboard pane requires direct sunlight for activation. More generally, the indoor photocatalytic film may have a higher level of photoactivity (e.g., it may be thicker, doped to shift absorption into the visible, and/or it may have a more highly photoactive composition) than the outdoor photocatalytic film. When provided, the films comprising titanium oxide may, of course, be applied over one or more other films. For example, a first titanium oxide containing film can be provided over a flash-treated transparent electrically conductive coating on the external surface 12 of pane 10 while a second titanium oxide containing film is provided over a flash-treated transparent electrically conductive coating on the external surface 18 of pane 10'.

The IG unit 110 can optionally include one or more low-emissivity coatings 80. In the embodiment of Figure 9, the IG unit 110 includes a low-emissivity coating 80 on the internal surface 14 of pane 10. When provided, the low-emissivity coating 80 preferably includes at least one silver-inclusive film, which may contain more than 50% silver by weight (e.g., a metallic silver film). If desired, a low-emissivity coating can alternatively be on the internal surface 16 of pane 10'. In some embodiments, the low-emissivity coating includes three or more infrared-reflective films (e.g., silver-containing films). Low-emissivity coatings with three or more infrared-reflective films are described in U.S. Patent and Application Nos. 11/546,152 and 7,572,511 and 7,572,510 and 7,572,509 and 11/545,211 and 7,342,716 and 7,339,728. In other cases, the low-emissivity coating can be a "single silver" or "double silver" low-emissivity coating, which are well known to skilled artisans.

If desired, the embodiment of Figure 6 can have a low-emissivity coating on surface 14, on surface 16, or both. The same is true of the embodiments of Figures 7 and 8. Similarly, the embodiment of Figure 9 can optionally have a low-emissivity coating on surface 16, in addition to (or instead of) having the illustrated low-emissivity coating 80 on surface 14. As another example, the embodiment of Figure 10 can optionally have a low-emissivity coating on surface 16, in addition to having the illustrated flash-treated transparent electrically conductive coating 7 on surface 14. In another embodiment, the flash-treated transparent electrically conductive coating is provided on surface 16, optionally in combination with providing a low-emissivity coating on surface 14.

While the embodiment of Figure 5 shows the flash-treated transparent electrically conductive coating 7 being on the #4 surface, any other surface (12, 14, or 16) of the IG unit 110 can alternatively be provided with a flash-treated transparent electrically conductive coating. In some embodiments, both external surfaces of an IG unit have flash-treated transparent electrically conductive coatings. For example, the IG unit 110 of Figure 7 has a first flash-treated transparent electrically conductive coating 7 on the #4 surface, while a second flash-treated transparent electrically conductive coating 7' is on the #1 surface. For triple glazed IG units, a first flash-treated transparent electrically conductive coating can be provided on the #6 surface of the IG unit, while a second flash-treated transparent electrically conductive coating is provided on the #1 surface of the IG unit. Or, there can simply be a single flash-treated transparent electrically conductive coating on the #1 surface, the #2 surface, the #3 surface, the #4 surface, the #5 surface, or the #6 surface.

Thus, it can be appreciated that the flash-treated transparent electrically conductive coating can be provided on any one or more surfaces of an IG unit. When applied on the #1 surface, the outboard pane will stay warmer and have less condensation. When applied on an internal surface (such as a #2 surface, a #3 surface, or a #5 surface) of the IG unit, the coating 7 can provide an advantageous passive solar control solution. When applied on an external #4 or #6 surface, the inboard pane will stay cooler and save energy, but it may catch condensation. In such cases, a hydrophilic and/or photocatalytic coating may be provided over the flash-treated transparent electrically conductive coating so as to encourage rapid evaporation of any condensation that may occur. The flash-treated transparent electrically conductive coating may also be beneficial for a monolithic glazing, a laminated glass glazing, etc.

The flash-treated transparent electrically conductive coating has a number of beneficial properties. The ensuing discussion reports several of these properties. In some cases, properties are reported herein for a single (e.g., monolithic) pane 10' bearing the flash-treated transparent electrically conductive coating on one surface 18 ("the present pane"). In other cases, these properties are reported for a double-pane IG unit 110 having the flash-treated transparent electrically conductive coating on the #4 surface 18 and a triple-silver low-emissivity coating on the #2 surface. The triple-silver low-emissivity coating is known commercially as the LoE³-366 product from Cardinal CG Company. In such cases, the reported properties are for a double-pane IG unit wherein both panes are clear 2.2 mm annealed soda lime float glass with a ½ inch between-pane space filled with an insulative gas mix of 90% argon and 10% air ("the present IG unit"). Of course, these specifics are by no means limiting to the invention. For example, the flash-treated transparent electrically conductive coating can alternatively be provided on the #1 surface of the IG unit, the low-emissivity coating can alternatively be on the #3 surface, the low-emissivity coating can alternatively be a single or double silver low-emissivity coating, etc. Absent an express statement to the contrary, the present discussion reports determinations made using the well-known WINDOW 7.1 computer program (e.g., calculating center of glass data) under NFRC100-2010 conditions.

The flash-treated coating 7 provides low emissivity. The emissivity of the coating 7 is less than 0.35, such as from 0.05 to 0.28. In some embodiments, the emissivity is less than 0.22, less than 0.2, or even less than 0.18, such as about 0.15. In contrast, an uncoated pane of clear glass would typically have an emissivity of about 0.84.

The term "emissivity" is well known in the present art. This term is used herein in accordance with its well-known meaning to refer to the ratio of radiation emitted by a surface to the radiation emitted by a blackbody at the same temperature. Emissivity is a characteristic of both absorption and reflectance. It is usually represented by the formula: E = 1 - Reflectance. The present emissivity values can be determined as specified in "Standard Test Method for Emittance of Specular Surfaces Using Spectrometric Measurements," NFRC 301-2010, the entire teachings of which are incorporated herein by reference.

In addition to low emissivity, the U Value of the present IG unit 110 is very low. As is well known, the U Value of an IG unit is a measure of the thermal insulating property of the unit. The smaller the U value, the better the insulating property of the unit. The U Value of the present IG unit is less than 0.3 (i.e., center of glass U value), preferably less than 0.25, and perhaps optimally 0.24 or less, such as from 0.20-0.23.

The term U Value is well known in the present art. It is used herein in accordance with its well-known meaning to express the amount of heat that passes through one unit of area in one unit of time for each unit of temperature difference between a hot side of the IG unit and a cold side of the IG unit. The U Value can be determined in accordance with the standard specified for U_{winter} in NFRC 100-2014.

A tradeoff is sometimes made in low U value coatings whereby the film(s) selected to achieve a low U value have the effect of decreasing the visible transmittance to a lower level than is desired and/or increasing the visible reflectance to a higher level than is ideal. As a consequence, windows bearing these coatings may have unacceptably low visible transmission, a somewhat mirror-like appearance, or suboptimal color properties.

In combination with the beneficial properties discussed above, the flash-treated coating 7 has good optical properties. As noted above, a tradeoff is sometimes made in low U value coatings whereby the films selected to achieve a low U value have the effect of restricting the visible transmission to a level that is lower than ideal.

To the contrary, the present coating 7 provides an exceptional combination of these properties. For example, the present IG unit 110 (and the present pane 10', whether monolithic or as part of the IG unit 110) has a visible transmittance Tᵥ of greater than 0.5 (i.e., a visible transmission of greater than 50%). Preferably, the present IG unit 110 (and the present pane 10', whether monolithic or insulated) achieves a visible transmittance Tᵥ of greater than 0.60 (i.e., a visible transmission of greater than 60%), or greater than 0.62 (i.e., a visible transmission of greater than 62%), such as about 0.63.

Further, if the triple silver low-emissivity coating is replaced with a double silver low-emissivity coating like the LOE²-270™ or LoE²-272™ coatings from Cardinal CG Company, the present IG unit 110 (and the present pane 10', whether monolithic or insulated) can exhibit a visible transmittance Tᵥ of greater than 0.65 (i.e., a visible transmission of greater than 65%), or even greater than 0.68, such as about 0.69-0.70.

Moreover, if the triple silver low-emissivity coating is replaced with a single silver low-emissivity coating like the LoE-180™ coating from Cardinal CG Company, the present IG unit 110 (and the present pane 10', whether monolithic or insulated) can exhibit a visible transmittance Tᵥ of greater than 0.70 (i.e., a visible transmission of greater than 70%), or even greater than 0.75, such as about 0.77.

While the desired level of visible transmission can be selected and varied to accommodate different applications, preferred embodiments provide a coated pane 10' having a post-flash-treatment monolithic visible transmission of greater than 82%, greater than 85%, or even greater than 86%, such as greater than 86% but less than 92%.

The term "visible transmission" is well known in the art and is used herein in accordance with its well-known meaning to refer to the percentage of all incident visible radiation that is transmitted through the IG unit 110. Visible radiation constitutes the wavelength range of between about 380 nm and about 780 nm. Visible transmittance, as well as visible reflectance, can be determined in accordance with NFRC 300-2014, Standard Test Method for Determining the Solar and Infrared Optical Properties of Glazing Materials and Fading Resistance of Systems. The well-known WINDOW 7.1 computer program can be used in calculating these and other reported optical properties.

The flash-treated electrically conductive coating 7 can provide desirable reflected color properties in combination with excellent thermal insulating properties. For example, the present IG unit 110 can optionally exhibit an exterior reflected color characterized by an "a" color coordinate of between -7 and 2 (e.g., between -5 and 1, such as about -1.9) and a "b" color coordinate of between -9 and 0 (e.g., between -6 and -1, such as about -3.4).

The present discussion of color properties is reported using the well-known color coordinates of "a" and "b." In more detail, the reported color coordinates result from conventional use of the well-known Hunter Lab Color System (Hunter methods/units, Ill. D65, 10 degree observer). The present color properties can be determined as specified in ASTM Method E 308.

In certain embodiments, the foregoing color properties are provided in combination with the sheet resistance, emissivity, U value, and visible transmission properties reported above. For example, the following chart depicts preferred combinations of properties in accordance with certain embodiments (the tabulated properties are after flash treatment).

| | preferred | more preferred |
|---|---|---|
| Sheet resistance | less than 15 Ω/square | less than 13 Ω/square |
| emissivity | less than 0.25 | less than 0.18 |
| U value | less than 0.3 | less than 0.25 |
| T_{v monolithic} | greater than 82% | greater than 86% |

In one embodiment, a multiple-pane insulating glazing unit includes an internal pane surface bearing a low-emissivity coating that has only one film comprising silver. The multiple-pane insulating glazing unit includes two glass panes and a between-pane space. The two glass panes respectively define two opposed external pane surfaces. The low-emissivity coating is exposed to the between-pane space of the IG unit. The film comprising silver preferably contains at least 50% silver by weight. A desired one of the two external pane surfaces has a flash-treated transparent conductive oxide coating, such that a desired one of the two glass panes is a coated glass pane. This coated glass pane is annealed glass having a surface stress of less than 3,500 psi. The transparent conductive oxide coating comprises a flash-treated indium tin oxide film and an overcoat film. The flash-treated indium tin oxide film has a thickness of less than 1,800 Å and is a sputtered film having a surface roughness of less than 3 nm. In the present embodiments, the flash-treated indium tin oxide film has a sheet resistance of less than 15 ohms/square in combination with the coated pane having a monolithic visible transmittance of greater than 0.82. The flash-treated indium tin oxide film has an optical bandgap of 370 nm or shorter and is characterized by a pre-flash optical bandgap of 400 nm or longer. In the present embodiments, the IG unit has a U value of less than 0.25 together with an IGU visible transmission of greater than 75%. In this embodiment, the IG unit preferably exhibits an exterior reflected color characterized by an "a" color coordinate of between -6 and 0 and a "b" color coordinate of between -8 and -1.

In another embodiment, a multiple-pane insulating glazing unit includes an internal pane surface bearing a low-emissivity coating that has only two films comprising silver. The multiple-pane insulating glazing unit includes two glass panes and a between-pane space. The two glass panes respectively define two opposed external pane surfaces. Preferably, each film comprising silver contains at least 50% silver by weight. The low-emissivity coating is exposed to the between-pane space of the IG unit. The two glass panes respectively define two opposed external pane surfaces. A desired one of the two external pane surfaces has a flash-treated transparent conductive oxide coating, such that a desired one of the two glass panes is a coated glass pane. This coated glass pane is annealed glass having a surface stress of less than 3,500 psi. The transparent conductive oxide coating comprises a flash-treated indium tin oxide film and an overcoat film. The flash-treated indium tin oxide film has a thickness of less than 1,800 Å and is a sputtered film having a surface roughness of less than 3 nm. In the present embodiments, the flash-treated indium tin oxide film has a sheet resistance of less than 15 Q/square in combination with the desired pane having a monolithic visible transmittance of greater than 0.82. The flash-treated indium tin oxide film has an optical bandgap of 370 nm or shorter and is characterized by a pre-flash optical bandgap of 400 nm or longer. In the present embodiment, the multiple-pane insulating glazing unit has a U value of less than 0.25 together with an IGU visible transmission of greater than 65%. In this embodiment, the IG unit preferably exhibits an exterior reflected color characterized by an "a" color coordinate of between -6 and 0 and a "b" color coordinate of between -8 and -1.

In still another embodiment, a multiple-pane insulating glazing unit includes an internal pane surface bearing a low-emissivity coating that includes three films comprising silver. The multiple-pane insulating glazing unit includes two glass panes and a between-pane space. The two glass panes respectively define two opposed external pane surfaces. Preferably, each film comprising silver contains at least 50% silver by weight. The low-emissivity coating is exposed to the between-pane space of the IG unit. A desired one of the two external pane surfaces has a flash-treated transparent conductive oxide coating, such that a desired one of the two glass panes is a coated glass pane. This coated glass pane is annealed glass having a surface stress of less than 3,500 psi. The transparent conductive oxide coating comprises a flash-treated indium tin oxide film and an overcoat film. The flash-treated indium tin oxide film has a thickness of less than 1,800 Å and is a sputtered film having a surface roughness of less than 3 nm. In the present embodiments, the flash-treated indium tin oxide film has a sheet resistance of less than 15 Q/square in combination with the coated pane having a monolithic visible transmittance of greater than 0.82. The flash-treated indium tin oxide film has an optical bandgap of 370 nm or shorter and is characterized by a pre-flash optical bandgap of 400 nm or longer. In the present embodiment, the multiple-pane insulating glazing unit has a U value of less than 0.25 together with an IGU visible transmission of greater than 60%. In this embodiment, the IG unit preferably exhibits an exterior reflected color characterized by an "a" color coordinate of between -6 and 1 and a "b" color coordinate of between -7 and -1.

In the foregoing three embodiments, the IG unit can be, for example, a double-pane unit with coating 7 on the #4 surface and the low-emissivity coating on the #2 surface. The flash-treated coating 7 can consist of the following layers: silicon dioxide at about 100Å/ITO (90% In/10% Sn) at about 1,200-1,400 Å/tin oxide at about 150Å/SiON at about 900Å. The low-emissivity coating in the first of the foregoing three embodiments can, for example, be a single-silver low-emissivity coating like the commercially available LoE-180™ coating from Cardinal CG Company of Eden Prairie, Minnesota, USA. The low-emissivity coating in the second of the foregoing three embodiments can, for example, be a double-silver low-emissivity coating like the commercially available LoE²-270™ or LoE²-272™ coatings from Cardinal CG Company. The low-emissivity coating in the third of the foregoing three embodiments can, for example, be a triple-silver low-emissivity coating like the commercially available LoE³-366™ coating from Cardinal CG Company. These single, double, and triple-silver low-emissivity coatings can optionally be used in any embodiment of the present disclosure where a single, double, or triple-silver low-emissivity coating is provided.

The invention provides one group of embodiments wherein the coating 7 has an intermediate level of electrical conductivity. In these embodiments, the post-flash-treatment sheet resistance and emissivity are higher than the preferred and more preferred ranges tabulated above. Specifically, the emissivity is in the range of from 0.25 to 0.55. The monolithic visible transmission of the flash-treated coated glass pane in these embodiments is greater than 75%, preferably greater than 80%, and more preferably greater than 85%, such as greater than 86% but less than 92%. The post-flash-treatment visible absorption of the coating 7 preferably is less than 5%, such as greater than 0.5% but less than 4.5%. In the present embodiments, the indium tin oxide film 20 preferably has a thickness of less than 1,500 Å, such as between 100 Å and 1,475 Å. In some of the present embodiments, the thickness of the indium tin oxide film 20 is greater than 100 Å but less than 1,100 Å, less than 750 Å, less than 500 Å, or even less than 300 Å. One exemplary coating 7 has a layer of ITO on a glass substrate, where the ITO layer has a thickness of about 1,060 Å. In this case, the emissivity is about 0.45. In another example, the coating 7 has the following layer stack: glass/ITO at about 170 Å/SnO₂ at about 1,135 Å/SiON at about 560 Å. In this example, the post-flash-treatment emissivity is about 0.5. In still another example, the coating 7 has the following layer stack: glass/ITO at about 520 Å/SnO₂ at about 785 A/SiON at about 560 Å. In this example, the post-flash-treatment emissivity is about 0.31. If desired, a base coat 15 of the nature described previously may be added to any of these film stacks. Additionally or alternatively, an uppermost layer comprising titanium oxide can optionally be added.

## Claims

1. A method of producing coated glass, the method comprising providing a glass pane having opposed first and second surfaces, the method further comprising sputtering a metallic indium tin target in an oxidizing atmosphere so as to deposit a substoichiometric indium tin oxide film on the first surface of the glass pane, thereby producing a coated glass pane, the substoichiometric indium tin oxide film having a thickness of less than 1,800 Å, a surface roughness of less than 3 nm, an optical bandgap of 400 nm or longer, and a carrier concentration of 5 x 10²⁰/cm³ or less, the method further comprising flash treating the substoichiometric indium tin oxide film so as to produce a flash-treated indium tin oxide film, the flash treating comprising flash lamp treatment at a peak pulse power of 15-45 kW/cm², the flash-treated indium tin oxide film having a thickness of less than 1,800 Å, a surface roughness of less than 3 nm, an optical bandgap of 370 nm or shorter, a carrier concentration of 9 x 10²⁰/cm³ or more, and a sheet resistance of less than 15 Q/square in combination with providing said coated glass pane with a monolithic visible transmittance of greater than 0.82, the substoichiometric indium tin oxide film being absorptive of energy emitted by a flash of the flash lamp treatment in the 370 to 400 nm range.

2. The method of claim 1 wherein said flash treatment produces a carrier concentration factor of at least 5.

3. The method of claim 1 wherein the carrier concentration of the flash-treated indium tin oxide film is 9-13 x10²⁰/cm³.

4. The method of claim 1 wherein the substoichiometric indium tin oxide film has a visible absorption of greater than 7%, and the flash-treated indium tin oxide film has a visible absorption of less than 5%.

5. The method of claim 1 wherein said flash treatment produces a Δ*A* of nine percent or more.

6. The method of claim 1 wherein the flash-treated indium tin oxide film has a thickness of less than 1,500 Å and yet its sheet resistance is less than 15 Q/square.

7. The method of claim 6 wherein the thickness of the flash-treated indium tin oxide film is between 1,050 Å and 1,450 Å in combination with the monolithic visible transmittance of said coated glass pane being greater than 0.86 but less than 0.92 and the sheet resistance being greater than 10 Q/square but less than 13 Q/square.

8. The method of claim 1 wherein the flash-treated indium tin oxide film is non-porous.

9. The method of claim 1 further comprising sputter depositing an overcoat film on the substoichiometric indium tin oxide film, the overcoat film being sputter deposited to a thickness of between 100 Å and 1,300 Å.

10. The method of claim 1 wherein the overcoat film is formed of an oxide material and is deposited directly onto the flash-treated indium tin oxide film, and the flash-treated indium tin oxide film is deposited directly onto the first surface of the glass pane, the flash-treated indium tin oxide film having a sodium concentration of less than 100 ppm.

11. The method of claim 1 wherein the surface roughness of the flash-treated indium tin oxide film is between 1.5 nm and 3 nm.

12. The method of claim 1 wherein the second surface of the glass pane is maintained at a temperature of 150 degrees C or less during said flash treatment.

13. The method of claim 1 wherein the thickness of the substoichiometric indium tin oxide film is between 1,050 Å and 1,450 Å.

14. The method of claim 1 wherein the optical bandgap of the substoichiometric indium tin oxide film is 410 nm or longer.

15. The method of claim 1 wherein the optical bandgap of the substoichiometric indium tin oxide film is 420 nm or longer.

## Patentansprüche

1. Verfahren zur Herstellung von beschichtetem Glas, wobei das Verfahren das Bereitstellen einer Glasscheibe mit einer ersten und einer zweiten Oberfläche, die einander entgegengesetzt sind, aufweist, wobei das Verfahren ferner Folgendes aufweist: Sputtern eines metallischen Indium-Zinn-Targets in einer oxidierenden Atmosphäre, um einen substöchiometrischen Indiumzinnoxidfilm auf die erste Oberfläche der Glasscheibe aufzubringen, wodurch eine beschichtete Glasscheibe hergestellt wird, wobei der substöchiometrische Indiumzinnoxidfilm eine Dicke von weniger als 1800 Ä, eine Oberflächenrauheit von weniger als 3 nm, eine optische Bandlücke von 400 nm oder länger und eine Trägerkonzentration von 5 x 10²⁰/cm³ oder weniger hat, wobei das Verfahren ferner Folgendes aufweist: das Blitzbehandeln des substöchiometrischen Indiumzinnoxids, um einen blitzbehandelten Indiumzinnoxidfilm herzustellen, wobei das Blitzbehandeln eine Blitzlampenbehandlung bei einer Pulsspitzenleistung von 15 - 45 kW/cm² aufweist, wobei der blitzbehandelte Indiumzinnoxidfilm eine Dicke von weniger als 1800 Ä, eine Oberflächenrauheit von weniger als 3 nm, eine optische Bandlücke von 370 nm oder kürzer, eine Trägerkonzentration von 9 x 10²⁰/cm³ oder mehr und einen Flächenwiderstand von weniger als 15 Ω/Quadrat hat, in Kombination mit dem Versehen der genannten beschichteten Glasscheibe mit einem monolithischen Lichttransmissionsgrad von mehr als 0,82, wobei der substöchiometrische Indiumzinnoxidfilm Energie absorbiert, die durch einen Blitz der Blitzlampenbehandlung im Bereich von 370 bis 400 nm emittiert wird.

2. Verfahren nach Anspruch 1, wobei die genannte Blitzbehandlung einen Trägerkonzentrationsfaktor von wenigstens 5 ergibt.

3. Verfahren nach Anspruch 1, wobei die Trägerkonzentration des blitzbehandelten Indiumzinnoxidfilms 9 - 13 x 10²⁰/cm³ ist.

4. Verfahren nach Anspruch 1, wobei der substöchiometrische Indiumzinnoxidfilm eine Absorption im sichtbaren Bereich von mehr als 7 % hat und der blitzbehandelte Indiumzinnoxidfilm eine Absorption im sichtbaren Bereich von weniger als 5 % hat.

5. Verfahren nach Anspruch 1, wobei die genannte Blitzbehandlung eine Δ*A* von neun Prozent oder mehr ergibt.

6. Verfahren nach Anspruch 1, wobei der blitzbehandelte Indiumzinnoxidfilm eine Dicke von weniger als 1500 Å hat und sein Flächenwiderstand jedoch kleiner als 15 Ω/Quadrat ist.

7. Verfahren nach Anspruch 6, wobei die Dicke des blitzbehandelten Indiumzinnoxidfilms in Kombination damit, dass der monolithische Transmissionsgrad im sichtbaren Bereich der genannten beschichteten Glasscheibe größer als 0,86 aber kleiner als 0,92 ist und der Flächenwiderstand größer als 10 Ω/Quadrat aber kleiner als 13 Ω/Quadrat ist, zwischen 1050 und 1450 Å ist.

8. Verfahren nach Anspruch 1, wobei der blitzbehandelte Indiumzinnoxidfilm nichtporös ist.

9. Verfahren nach Anspruch 1, das ferner das Aufbringen eines Überzugsfilms durch Sputtern auf den substöchiometrischen Indiumzinnoxidfilm aufweist, wobei der Überzugsfilm durch Sputtern auf eine Dicke zwischen 100 Å und 1300 Å aufgebracht wird.

10. Verfahren nach Anspruch 1, wobei der Überzugsfilm aus einem Oxidmaterial hergestellt wird und direkt auf den blitzbehandelten Indiumzinnoxidfilm aufgebracht wird und der blitzbehandelte Indiumzinnoxidfilm direkt auf die erste Oberfläche der Glasscheibe aufgebracht wird, wobei der blitzbehandelte Indiumzinnoxidfilm eine Natriumkonzentration von weniger als 100 ppm hat.

11. Verfahren nach Anspruch 1, wobei die Oberflächenrauheit des blitzbehandelten Indiumzinnoxidfilms zwischen 1,5 nm und 3 nm ist.

12. Verfahren nach Anspruch 1, wobei die zweite Oberfläche der Glasscheibe während der genannten Blitzbehandlung auf einer Temperatur von 150 Grad C oder weniger gehalten wird.

13. Verfahren nach Anspruch 1, wobei die Dicke des substöchiometrischen Indiumzinnoxidfilms zwischen 1050 Ä und 1450 Å ist.

14. Verfahren nach Anspruch 1, wobei die optische Bandlücke des substöchiometrischen Indiumzinnoxidfilms 410 nm oder länger ist.

15. Verfahren nach Anspruch 1, wobei die optische Bandlücke des substöchiometrischen Indiumzinnoxidfilms 420 nm oder länger ist.

## Revendications

1. Procédé de production de verre revêtu, le procédé comprenant la fourniture d'un panneau de verre présentant des première et seconde surfaces opposées, le procédé comprenant en outre la pulvérisation d'une cible d'indium-étain métallique dans une atmosphère oxydante de manière à déposer un film d'oxyde d'indium-étain sous-stœchiométrique sur la première surface du panneau de verre, produisant ainsi un panneau de verre revêtu, le film d'oxyde d'indium-étain sous-stœchiométrique ayant une épaisseur de moins de 1800 Å, une rugosité de surface de moins de 3 nm, une bande interdite optique de 400 nm ou plus, et une concentration de porteurs de 5×10²⁰/cm³ ou moins, le procédé comprenant en outre le traitement au flash du film d'oxyde d'indium-étain sous-stœchiométrique de manière à produire un film d'indium-étain traité au flash, ledit traitement au flash comprenant un traitement par lampe flash à une puissance impulsionnelle maximale de 15 à 45 kW/cm², le film d'oxyde d'indium-étain traité au flash présentant une épaisseur de moins de 1800 Å, une rugosité de surface de moins de 3 nm, une bande interdite optique de 370 nm ou plus courte, une concentration de porteurs de 9 x 10²⁰/cm³ ou plus, et une résistance de feuille de moins de 15 Q/carré en plus de conférer audit panneau de verre revêtu une transmittance visible monolithique de plus de 0,82, le film d'oxyde d'indium-étain sous-stœchiométrique absorbant l'énergie émise par un flash du traitement par lampe flash dans la plage de 370 à 400 nm.

2. Procédé selon la revendication 1 dans lequel ledit traitement au flash produit un facteur de concentration de porteurs d'au moins 5.

3. Procédé selon la revendication 1 dans lequel la concentration de porteurs du film d'oxyde d'indium-étain traité au flash est de 9 à 13×10²⁰/cm³.

4. Procédé selon la revendication 1 dans lequel le film d'oxyde d'indium-étain sous-stœchiométrique présente une absorption visible de plus de 7 %, et le film d'oxyde d'indium-étain traité au flash présente une absorption visible de moins de 5 %.

5. Procédé selon la revendication 1 dans lequel ledit traitement au flash produit un Δ*A* de neuf pour cent ou plus.

6. Procédé selon la revendication 1 dans lequel le film d'oxyde d'indium-étain traité au flash présente une épaisseur de moins de 1500 Å avec toutefois une résistance de feuille de moins de 15 Q/carré.

7. Procédé selon la revendication 6 dans lequel l'épaisseur du film d'oxyde d'indium-étain traité au flash est comprise entre 1050 Å et 1450 Å pour une transmittance visible monolithique dudit panneau de verre revêtu supérieure à 0,86 mais inférieure à 0.92 et une résistances de feuille supérieure à 10 Q/carré mais inférieure à 13 Q/carré.

8. Procédé selon la revendication 1 dans lequel le film d'oxyde d'indium-étain traité au flash est non poreux.

9. Procédé selon la revendication 1 comprenant le dépôt par pulvérisation d'un film de recouvrement sur le film d'oxyde d'indium-étain sous-stœchiométrique, le film de recouvrement étant déposé par pulvérisation jusqu'à une épaisseur entre 100 Å et 1300 Å.

10. Procédé selon la revendication 1 dans lequel le film de recouvrement est formé d'un matériau d'oxyde et déposé directement sur le film d'oxyde d'indium-étain traité au flash, et le film d'oxyde d'indium-étain traité au flash est déposé directement sur la première surface du panneau de verre, le film d'oxyde d'indium-étain traité au flash présentant une concentration de sodium de moins de 100 ppm.

11. Procédé selon la revendication 1 dans lequel la rugosité de surface du film d'oxyde d'indium-étain traité au flash est comprise entre 1,5 nm et 3 nm.

12. Procédé selon la revendication 1 dans lequel la seconde surface du panneau de verre est maintenue à une température de 150 degrés C ou moins durant ledit traitement au flash.

13. Procédé selon la revendication 1 dans lequel l'épaisseur du film d'oxyde d'indium-étain sous-stœchiométrique est comprise entre 1050 Å et 1450 Å.

14. Procédé selon la revendication 1 dans lequel la bande interdite optique du film d'oxyde d'indium-étain sous-stœchiométrique est 410 nm ou plus.

15. Procédé selon la revendication 1 dans lequel la bande interdite optique du film d'oxyde d'indium-étain sous-stœchiométrique est 420 nm ou plus.
